# EUROPÄISCHE PATENTSCHRIFT

(11) **EP 1 560 477 B1**
(45) Veröffentlichungstag und Bekanntmachung des Hinweises auf die Patenterteilung: **30.01.2008**
(21) Anmeldenummer: 04106918.8
(22) Anmeldetag: 23.12.2004
(51) Int. Cl.: H05K 5/04, H05K 7/20, B60R 11/02

(54) **Multimediaeinheit**
Multimedia unit
Ensemble multimédia

(30) Priorität: 29.01.2004 DE 102004004592
(43) Veröffentlichungstag der Anmeldung: 03.08.2005
(73) Patentinhaber: Siemens VDO Automotive AG, 93055 Regensburg (DE)
(72) Erfinder: Dinkel, Alexander, 93047, Regensburg (DE); Pfandler, Georg, 92421, Schwandorf (DE)

(56) Entgegenhaltungen:
- DE-A1- 3 717 009
- US-A- 6 011 701
- "DEVICE POWER/LOGIC ASSEMBLY" IBM TECHNICAL DISCLOSURE BULLETIN, IBM CORP. NEW YORK, US, Bd. 33, Nr. 7, 1. Dezember 1990 (1990-12-01), Seiten 166-168, XP000108411 ISSN: 0018-8689
- PATENT ABSTRACTS OF JAPAN Bd. 2003, Nr. 09, 3. September 2003 (2003-09-03) -& JP 2003 127792 A (KENWOOD CORP), 8. Mai 2003 (2003-05-08)

## Beschreibung

Die Erfindung bezieht sich auf eine Multimediaeinheit zur Anordnung in einem Kraftfahrzeug, mit einem als Metallgussteil ausgebildeten Gehäuse, , wobei in dem Gehäuse Ausnehmungen und/oder Aufnahmen und/oder Auflageelemente zur Positionierung und/oder Halterung von insbesondere elektrischen und/oder elektronischen Bauteilen ausgebildet sind und wobei die Außenwände des Gehäuses eine elektromagnetische Schirmung bilden und elektrische und/oder elektronische Bauteile und/oder elektrische und/oder elektronische Bauteile tragende Leiterplatten wärmeleitend mit Wänden und/oder Böden des Gehäuses verbunden sind, *das aus mehreren Teilgehäusen besteht, die miteinander verbindbar sind.*

Aus der DE 37 17 009 A1 ist eine Einheit der eingangs genannten Art bekannt.

Aus der "Device Power/Logic Assembly" IBM Technical Disclosure Bulletin, IBM Corp. New York, Bd. 33, Nr. 7, 1. Dezember 1990, Seiten 166-168, XP000108411 ISSN: 0018-8689 ist eine Einheit bekannt, die sandwichartig zwischen mehreren kasten- oder rahmenartigen Gehäuseteilen Leiterplatten aufweist, die elektrische und/oder elektronische Bauteile tragen. Die Gehäuseteile und Leiterplatten sind durch Positionierpins zueinander ausgerichtet und mittels Schrauben zusammengeschraubt. Ein rahmenartiges Gehäuseteil besitzt Lüftungsöffnungen.

Aufgabe der Erfindung ist es eine Multimediaeinheit der eingangs genannten Art zu schaffen, die einfach herstellbar ist, sowie eine gute elektromagnetische Abschirmung und eine gute Ableitung der von den elektrischen und elektronischen Bauteilen erzeugten Wärme ermöglichen.

Diese Aufgabe wird erfindungsgemäß dadurch gelöst, dass die Teilgehäuse durch in den Teilgehäusen ausgebildete Steck- und/oder Fügeelemente zu dem Gehäuse fügbar und durch Verbindungselemente verbindbar sind, *wobei die Steck- und*/*oder Fügeelemente einteilig mit einem Teilgehäuse verbunden e, hervorstehende Zapfen oder Ansätze sind, die in entsprechende an einem anderen Teilgehäuse ausgebildete Ausnehmungen einsetzbar sind* und dass in jedem Teilgehäuse die funktionsfertig miteinander verbundenen Bauteile einer oder mehrerer Komponenten der Multimediaeinheit angeordnet sind, wobei ein oder mehrere Teilgehäuse etwa topfartig ausgebildet sind und die Topföffnung eines oder mehrerer Teilgehäuse eine zum Gehäuseäußeren führende Öffnung in einer Gehäusewand aufweist, in der ein Lüfter angeordnet ist, wobei in der den Lüfter aufweisenden Gehäusewand gegenüberliegenden Gehäusewand der Topföffnung Lüftungsöffnungen ausgebildet sind.

Die Teilgehäuse sind gleichzeitig Komponenten des Gehäuses und bilden die Trägerkonstruktion für die elektrischen und elektronischen Bauteile, welche und leicht miteinander verbindbar und voneinander lösbar sind.

Dabei können die einfach und ohne wesentliche Nachbearbeitung herstellbaren Teilgehäuse separat voll funktionsfähig vormontiert werden, ehe dann der Zusammenbau der Multimediaeinheit erfolgt.

Dies ermöglicht auch einen einfachen zum Beispiel reparaturbedingten Austausch eines Teilgehäuses.
Darüber hinaus kann auch eine Mehrzahl anwendungsabhängig unterschiedlich zusammengesetzter Typen an Multimediaeinheiten bereitgestellt werden.

Die Gehäusewände erfüllen eine Doppelfunktion, indem sie sowohl eine Abschirmung gegen elektromagnetische Störungen der in dem Gehäuse befindlichen Elektroniken bewirken, als auch für die Ableitung der von den elektrischen und elektronischen Komponenten erzeugten Wärme sorgen.

Die Abfuhr der erwärmten Luft erfolgt mittels des Lüfters durch die zum Gehäuseäußeren führende Öffnung in der Gehäusewand, während ein gutes Nachströmen von kühlerer Luft von außen durch die Lüftungsöffnungen erfolgt.

Die einteilig mit einem Teilgehäuse verbundenen hervorstehenden Zapfen oder Ansätze und die entsprechenden an einem anderen Teilgehäuse ausgebildeten Ausnehmungen dienen zur Montagevereinfachung und Bauteilereduzierung.

Die Komponenten der Multimediaeinheit können eine Spannungsversorgungseinheit und/oder eine Elektronikeinheit und/oder ein Laufwerk eines Datenspeichers insbesondere eines DVD- und/oder CD-Datenspeichers und/oder einer Wechslereinheit eines Datenspeichers insbesondere eines DVD- und/oder CD-Datenspeichers sein, wobei die Elektronikeinheit eine Telefonelektronik und/oder eine Navigationselektronik und/oder eine Radio- und Tunerelektronik und/oder eine GPS-Empfängerelektronik und/oder eine Sensoreinheit, insbesondere eine Drehwinkelsensoreinheit wie z.B. eine Gyroscope-Einheit aufweisen kann.

Zur Kommunikation untereinander sind die Komponenten der Multimediaeinheit vorzugsweise elektrisch miteinander kontaktierbar, wozu dazu die Komponenten lösbar elektrisch miteinander kontaktierbar sein können.

Dabei erfolgt eine montagefreundliche Kontaktierung zwangsläufig bei einem Zusammenbau der Teilgehäuse, wenn die Komponenten über je an einem Teilgehäuse fest angeordnete Stecker und/oder eine fest angeordnete Steckeraufnahme kontaktierbar sind.

Es ist aber auch möglich, dass die Komponenten über einen an flexiblen Leitern angeordneten Stecker und/oder eine an flexiblen Leitern angeordnete Steckeraufnahme kontaktierbar sind.

Eine gute unterschiedliche Kombinierbarkeit von Teilgehäusen wird dadurch ermöglicht, dass ein oder mehrere Teilgehäuse seriell zu einem Teilgehäusepaket miteinander verbindbar sind.

Darüber hinaus kann eine einfache Ergänzung des Teilgehäusepakets erfolgen, indem ein oder mehrere Teilgehäuse quer zur seriellen Anordnung der Teilgehäuse mit dem Teilgehäusepaket verbindbar sind.

Sowohl zu einer guten Abschirmung innerhalb der Komponenten als auch zu einer effektiven Wärmeableitung führt es, wenn ein oder mehrere Teilgehäuse eine umlaufende äußere Gehäusewand besitzen, wobei die etwa topfartig ausgebildeten Teilgehäuse einen Boden besitzen können, von dem Wärme von der Gehäusewand abgeführt werden kann.

Nach außen ist die Öffnung des Teilgehäuses vorzugsweise durch einen Deckel verschließbar, der dann ohne wesentliche Nachbearbeitung einfach herstellbar ist, wenn der Deckel ein Metallgussteil ist.

Eine Abgabe der Wärme nach außen und eine Abschirmung gegen äußere elektromagnetische Beeinflussung wird dadurch erreicht, dass die umlaufenden Gehäusewände und/oder die Deckel und/oder die Böden ganz oder teilweise die Außenwände des Gehäuses bilden.

Zur Vergrößerung der Wärmeabgabefläche können ein oder mehrere Teilgehäuse und/oder Deckel einteilig mit Kühlkörpern ausgebildet sein.

Eine weitere oder andere Möglichkeit zur Abgabe von Wärme nach außen besteht darin, dass ein oder mehrere Teilgehäuse und/oder Deckel durchgehende Lüftungsöffnungen aufweisen.

Eine sehr effektive Wärmeabgabe der elektrischen und elektronischen Bauteile wird dadurch erreicht, dass die elektrischen und/oder elektronischen Bauteile und/oder die elektrische und/oder elektronische Bauteile tragende Leiterplatte wärmeleitend mit einer Fläche des Bodens verbunden sind.

Dies ist besonders wirkungsvoll, wenn jede Fläche des Bodens mit elektrischen und/oder elektronischen Bauteilen und/oder mit elektrische und/oder elektronische Bauteile tragenden Leiterplatten wärmeleitend verbunden ist.

Ist der Boden oder der Deckel einteilig mit Luftleitschaufeln ausgebildet, so können die Luftströme optimal an den zu kühlenden elektrischen und elektronischen Bauteilen entlang geführt werden. Ein besonderer Herstellungs- und Montageaufwand für die Luftleitschaufeln fällt nicht an.

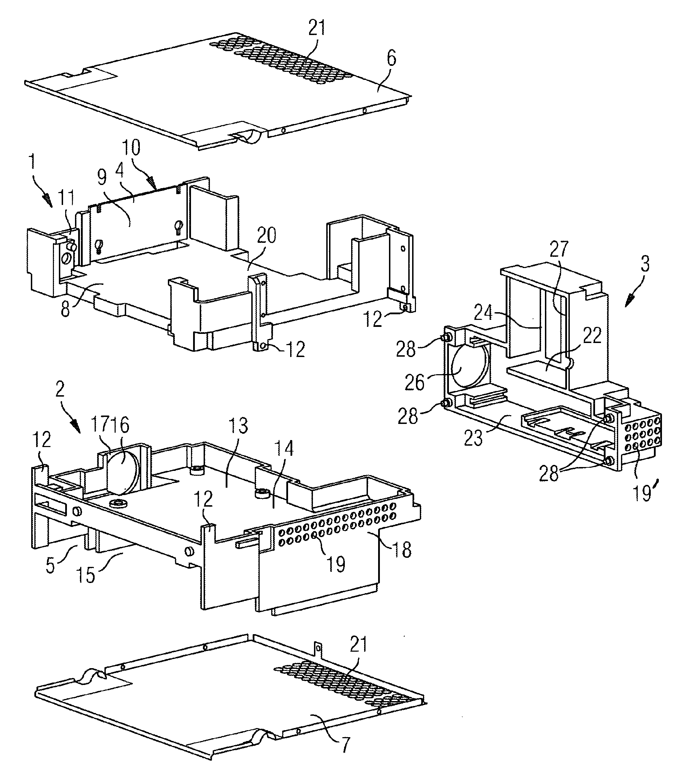

Ein Ausführungsbeispiel der Erfindung ist in der Zeichnung dargestellt und wird im Folgenden näher beschrieben.

Die einzige Figur der Zeichnung zeigt eine Explosionsdarstellung eines Gehäuses einer Multimediaeinheit. Das Gehäuse besteht aus einem etwa topfartigen ersten Teilgehäuse 1 und einem damit verbindbaren zweiten topfartigen Teilgehäuse 2 etwa gleichen Querschnitts, die seriell zu einem Teilgehäusepaket miteinander verbindbar sind. Quer zur seriellen Anordnung der Teilgehäuse 1 und 2 ist ein drittes topfartiges Teilgehäuse 3 mit dem Teilgehäusepaket verbindbar.

Die nach außen gerichteten Öffnungen 4 und 5 des ersten Teilgehäuses 1 und des zweiten Teilgehäuses 2 sind durch Deckel 6 und 7 verschließbar.

Sowohl die drei Teilgehäuse 1, 2 und 3 als auch die Deckel 6 und 7 sind Metallgussteile aus Aluminiumguss, die sehr maßgenau gegossen sind, so dass weitestgehend keine Bearbeitung erforderlich ist.

Die Ausgestaltung als Metallgussteil führt auch zu einer guten mechanischen Stabilität dieser Teile.

Die Außenwände der Teilgehäuse 1, 2 und 3 sind gerade und eben ausgebildet. Das erste Teilgehäuse 1 besitzt einen Boden 8, in dessen mittlerem Bereich ein Laufwerk eines Datenspeichers, insbesondere eines DVD- oder CD-Datenspeichers anordenbar ist.

Der eine Teil 9 der hinteren Außenwand 10 ist für die Anordnung eines GPS-Empfängers vorgesehen, während ein anderer Teil 11 der Außenwand 10 zur Anordnung einer Drehwinkelsensoreinheit vorgesehen ist.

Die von dem Laufwerk erzeugte Wärme wird direkt an den Boden 8 abgegeben und von dort den Außenwänden zugeführt, die die Wärme nach außen abstrahlen.

Durch hervorstehende Stecklaschen 12, die zu dem jeweils benachbarten Teilgehäuse 1 und 2 gerichtet sind, können die beiden Teilgehäuse 1 und 2 aufeinander gesteckt und ggf. durch Schraubverbindungen noch aneinander gesichert werden.

Das zweite Teilgehäuse 2 besitzt einen Mittelboden 13, von dessen umlaufendem Randbereich sich in beide Richtungen senkrecht zum Mittelboden 13 Außenwände erstrecken, so dass eine innere Kammer 14 und eine äußere Kammer 15 gebildet werden.

Die innere, zum ersten Teilgehäuse 1 gerichtete Kammer 14 wird durch den Boden 8 des ersten Teilgehäuses 1 abgedeckt. Ein auf der dem zweiten Teilgehäuse 2 zugewandten Seite des Bodens 8 anordenbare Telefonelektronik ragt somit in die innere Kammer 14 hinein. Die von der Telefonelektronik erzeugte Wärme wird durch einen Lüfter nach außen abgeführt. Dieser Lüfter ist in einer entsprechenden Öffnung 16 in der hinteren Außenwand 17 anordenbar. In der der hinteren Außenwand 17 gegenüberliegenden Außenwand 18 des zweiten Teilgehäuses 2 sind Lüftungsöffnungen 19 ausgebildet, durch die von dem Lüfter kühlere Außenluft in die innere Kammer 14 eingesogen wird. Die durch die Telefonelektronik erwärmte Luft führt der Lüfter dann nach außen ab.

In der äußeren Kammer 15 des zweiten Teilgehäuses 2 kann ein weiteres Laufwerk an dem Mittelboden 13 angeordnet werden, dessen erzeugte Wärme über den Mittelboden 13 zu den Außenwänden des zweiten Teilgehäuses 2 geleitet und von da nach außen abgestrahlt wird.

Die Wärme in der äußeren Kammer 15 wie auch in der Kammer 20 des ersten Teilgehäuses 1 wird zusätzlich über Lüftungsöffnungen 21 in den Deckeln 6 und 7 nach außen abgeführt. Diese Deckel 6 und 7 sind ebenfalls auf die Öffnungen 4 und 5 aufsteckbar und durch Schrauben sicherbar.

Das dritte Teilgehäuse 3 ist durch eine innere Gehäusewand 22 in eine Verstärkerkammer 23 und eine Spannungsversorgungskammer 24 unterteilt. In der Verstärkerkammer 23 ist ein Verstärker an der einen waagrechten Außenwand 25 anordenbar. Wie bei der inneren Kammer 14 sind in den beiden anderen einander gegenüberliegenden Außenwänden der Verstärkerkammer 24 eine Öffnung 26 zur Aufnahme eines Lüfters und Lüftungsöffnungen 19' ausgebildet, so dass durch den Lüfter ein kühlender Luftstrom in der Verstärkerkammer 23 erzeugt werden kann.

In der Spannungsversorgungskammer 24 ist auf dem eine Außenwand bildenden Boden 27 eine Spannungsversorgungseinheit anordenbar.

Das dritte Teilgehäuse 3 besitzt an seinem dem ersten und zweiten Teilgehäuse 1 und 2 zugewandten umlaufenden Randbereich hervorstehende Steckbolzen 28, die in entsprechende Ausnehmungen an dem ersten und zweiten Teilgehäuse 1 und 2 einführbar sind. Durch Schraubverbindungen kann zusätzlich noch eine Sicherung dieser Teilgehäuse aneinander erfolgen.

## Patentansprüche

1. Multimediaeinheit zur Anordnung in einem Kraftfahrzeug, mit einem als Metallgussteil (1, 2, 3, 6, 7) ausgebildeten Gehäuse, wobei in dem Gehäuse Ausnehmungen und/oder Aufnahmen und/oder Auflageelemente zur Positionierung und/oder Halterung von insbesondere elektrischen und/oder elektronischen Bauteilen ausgebildet sind und wobei die Außenwände (10, 17, 18) des Gehäuses eine elektromagnetische Schirmung bilden und elektrische und/oder elektronische Bauteile und/oder elektrische und/oder elektronische Bauteile tragende Leiterplatten wärmeleitend mit Wänden und/oder Böden des Gehäuses verbunden sind, *das aus mehreren Teilgehäusen (1, 2, 3) besteht, die miteinander verbindbar sind,* **dadurch gekennzeichnet, dass** die Teilgehäuse (1, 2, 3) durch in den Teilgehäusen (1, 2, 3) ausgebildete Steck- und/oder Fügeelemente zu dem Gehäuse fügbar und durch Verbindungselemente verbindbar sind, *wobei die Steck- und*/*oder Fügeelemente einteilig mit einem Teilgehäuse (1, 2, 3) verbundene, hervorstehende Zapfen oder Ansätze (12, 28) sind, die in entsprechende an einem anderen Teilgehäuse ausgebildete Ausnehmungen einsetzbar sind* und dass in jedem Teilgehäuse (1, 2, 3) die funktionsfertig miteinander verbundenen Bauteile einer oder mehrerer Komponenten der Multimediaeinheit angeordnet sind, wobei ein oder mehrere Teilgehäuse (1, 2, 3) etwa topfartig ausgebildet sind und die Topföffnung eines oder mehrerer Teilgehäuse eine zum Gehäuseäußeren führende Öffnung (16, 26) in einer Gehäusewand (17) aufweist, in der ein Lüfter angeordnet ist, wobei in der den Lüfter aufweisenden Gehäusewand (17) gegenüberliegenden Gehäusewand (18) der Topföffnung Lüftungsöffnungen (19, 19') ausgebildet sind.

2. Multimediaeinheit nach Anspruch 1, **dadurch gekennzeichnet, dass** die Komponenten der Multimediaeinheit eine Spannungsversorgungseinheit und/oder eine Elektronikeinheit und/oder ein Laufwerk eines Datenspeichers insbesondere eines DVD- und/oder CD-Datenspeichers und/oder einer Wechslereinheit eines Datenspeichers insbesondere eines DVD- und/oder CD-Daten-speichers sind.

3. Multimediaeinheit nach Anspruch 2, **dadurch gekennzeichnet, dass** die Elektronikeinheit eine Telefonelektronik und/oder eine Navigationselektronik und/oder eine Radio- und Tunerelektronik und/oder eine GPS-Empfängerelektronik und/oder eine Sensoreinheit, insbesondere eine Drehwinkelsensoreinheit aufweist.

4. Multimediaeinheit nach einem der vorhergehenden Ansprüche, **dadurch gekennzeichnet, dass** Komponenten der Multimediaeinheit elektrisch miteinander kontaktierbar sind.

5. Multimediaeinheit nach Anspruch 4, **dadurch gekennzeichnet, dass** die Komponenten lösbar elektrisch miteinander kontaktierbar sind.

6. Multimediaeinheit nach Anspruch 5, **dadurch gekennzeichnet, dass** die Komponenten über je an einem Teilgehäuse fest angeordnete Stecker und/oder eine fest angeordnete Steckeraufnahme kontaktierbar sind.

7. Multimediaeinheit nach einem der vorhergehenden Ansprüche, **dadurch gekennzeichnet, dass** die Komponenten über einen an flexiblen Leitern angeordneten Stecker und/oder eine an flexiblen Leitern angeordnete Steckeraufnahme kontaktierbar sind.

8. Multimediaeinheit nach einem der vorhergehenden Ansprüche, **dadurch gekennzeichnet, dass** mehrere Teilgehäuse (1, 2) seriell zu einem Teilgehäusepaket miteinander verbindbar sind.

9. Multimediaeinheit nach Anspruch 8, **dadurch gekennzeichnet, dass** ein oder mehrere Teilgehäuse (3) quer zur seriellen Anordnung der Teilgehäuse (1, 2) mit dem Teilgehäusepaket verbindbar sind.

10. Multimediaeinheit nach einem der vorhergehenden Ansprüche, **dadurch gekennzeichnet, dass** ein oder mehrere Teilgehäuse (1, 2, 3) eine umlaufende äußere Gehäusewand besitzen.

11. Multimediaeinheit nach Anspruch 10, **dadurch gekennzeichnet, dass** die Öffnung (4, 5) des Teilgehäuses (1, 2) durch einen Deckel (6, 7) verschließbar ist.

12. Multimediaeinheit nach Anspruch 11, **dadurch gekennzeichnet, dass** der Deckel (6, 7) ein Metallgussteil ist.

13. Multimediaeinheit nach einem der Ansprüche 10 bis 12, **dadurch gekennzeichnet, dass** die umlaufenden Gehäusewände (10, 17, 18) und/oder die Deckel (6, 7) und/oder die Böden (27) ganz oder teilweise die Außenwände des Gehäuses bilden.

14. Multimediaeinheit nach einem der vorhergehenden Ansprüche, **dadurch gekennzeichnet, dass** ein oder mehrere Teilgehäuse und/oder Deckel einteilig mit Kühlkörpern ausgebildet sind.

15. Multimediaeinheit nach einem der vorhergehenden Ansprüche, **dadurch gekennzeichnet, dass** ein oder mehrere Teilgehäuse (2, 3) und/oder Deckel durchgehende Lüftungsöffnungen (19, 19') aufweisen.

16. Multimediaeinheit nach einem der vorhergehenden Ansprüche, **dadurch gekennzeichnet, dass** die elektrischen und/oder elektronischen Bauteile und/oder die elektrische und/oder elektronische Bauteile tragende Leiterplatte wärmeleitend mit einer Fläche des Bodens (8) verbunden sind.

17. Multimediaeinheit nach Anspruch 16, **dadurch gekennzeichnet, dass** jede Fläche des Bodens mit elektrischen und/oder elektronischen Bauteilen und/oder mit elektrische und/oder elektronische Bauteile tragenden Leiterplatten wärmeleitend verbunden ist.

18. Multimediaeinheit nach einem der vorhergehenden Ansprüche, **dadurch gekennzeichnet, dass** der Boden oder der Deckel einteilig mit Luftleitschaufeln ausgebildet ist.

## Claims

1. Multimedia unit for arrangement in a motor vehicle, said unit having a housing which is in the form of a metal casting (1, 2, 3, 6, 7), recesses and/or receptacles and/or bearing elements for positioning and/or mounting electrical and/or electronic parts, in particular, being formed in the housing, and the outer walls (10, 17, 18) of the housing forming an electromagnetic screen, and electrical and/or electronic parts and/or printed circuit boards carrying electrical and/or electronic parts being thermally conductively connected to walls and/or bases of the housing which comprises a plurality of housing elements (1, 2, 3) which can be connected to one another, **characterized in that** the housing elements (1, 2, 3) can be joined to the housing using plug and/or joining elements, which are formed in the housing elements (1, 2, 3), and can be connected using connecting elements, the plug and/or joining elements being projecting pins or attachments (12, 28) which are integrally connected to a housing element (1, 2, 3) and can be inserted into corresponding recesses formed in another housing element, and **in that** the parts of one or more components of the multimedia unit, which are connected to one another such that they are ready for operation, are arranged in each housing element (1, 2, 3), one or more housing elements (1, 2, 3) being formed in a pot-like manner, for instance, and the pot opening of one or more housing elements having an opening (16, 26) in a housing wall (17), which leads to the exterior of the housing and in which a fan is arranged, ventilation openings (19, 19') being formed **in that** housing wall (18) of the pot opening which is opposite the housing wall (17) having the fan.

2. Multimedia unit according to Claim 1, **characterized in that** the components of the multimedia unit are a voltage supply unit and/or an electronic unit and/or a drive of a data memory, in particular a DVD data memory and/or a CD data memory, and/or a changer unit of a data memory, in particular a DVD data memory and/or a CD data memory

3. Multimedia unit according to Claim 2, **characterized in that** the electronic has telephone electronics and/or navigation electronics and/or radio and tuner electronics and/or GPS receiver electronics and/or a sensor unit, in particular a rotational angle sensor unit.

4. Multimedia unit according to one of the preceding claims, **characterized in that** components of the multimedia unit can be electrically contact-connected to one another.

5. Multimedia unit according to Claim 4, **characterized in that** the components can be electrically contact-connected to one another in a releasable manner.

6. Multimedia unit according to Claim 5, **characterized in that** the components can be contact-connected using respective plugs which are permanently arranged on a housing element and/or using a permanently arranged plug receptacle.

7. Multimedia unit according to one of the preceding claims, **characterized in that** the components can be contact-connected using a plug which is arranged on flexible conductors and/or using a plug receptacle which is arranged on flexible conductors.

8. Multimedia unit according to one of the preceding claims, **characterized in that** a plurality of housing elements (1, 2) can be connected to one another in series to form a housing element package.

9. Multimedia unit according to Claim 8, **characterized in that** one or more housing elements (3) can be connected to the housing element package in a manner transverse to the serial arrangement of the housing elements (1, 2).

10. Multimedia unit according to one of the preceding claims, **characterized in that** one or more housing parts (1, 2, 3) have a circumferential outer housing wall.

11. Multimedia unit according to Claim 10, **characterized in that** the opening (4, 5) of the housing element (1, 2) can be closed by means of a cover (6, 7).

12. Multimedia unit according to Claim 11, **characterized in that** the cover (6, 7) is a metal casting.

13. Multimedia unit according to one of Claims 10 to 12, **characterized in that** the circumferential housing walls (10, 17, 18) and/or the covers (6, 7) and/or the bases (27) completely or partially form the outer walls of the housing.

14. Multimedia unit according to one of the preceding claims, **characterized in that** one or more housing elements and/or covers may be integrally formed with heat sinks.

15. Multimedia unit according to one of the preceding claims, **characterized in that** one or more housing elements (2, 3) and/or covers have continuous ventilation openings (19, 19').

16. Multimedia unit according to one of the preceding claims, **characterized in that** the electrical and/or electronic parts and/or the printed circuit boards carrying electrical and/or electronic parts are thermally conductively connected to an area of the base (8).

17. Multimedia unit according to Claim 16, **characterized in that** every area of the base is thermally conductively connected to electrical and/or electronic parts and/or to printed circuit boards carrying electrical and/or electronic parts.

18. Multimedia unit according to one of the preceding claims, **characterized in that** the base or the cover is integrally formed with air directing blades.

## Revendications

1. Ensemble multimédia destiné à être installé dans un véhicule automobile et comportant un boîtier conçu sous la forme d'une pièce coulée en métal (1, 2, 3, 6, 7), où sont ménagés, dans le boîtier, des évidements et/ou des logements et/ou des éléments d'appui permettant de positionner et/ou de maintenir notamment des composants électriques et/ou électroniques et où les parois extérieures (10, 17, 18) du boîtier forment un écran électromagnétique et où des composants électriques et/ou électroniques et/ou des cartes à circuits imprimés portant des composants électriques et/ou électroniques sont liés, en assurant une conduction thermique, à des parois et/ou à des bases du boîtier, lequel se compose de plusieurs boîtiers partiels (1, 2, 3) qui peuvent être liés les uns aux autres, **caractérisé par le fait que** les boîtiers partiels (1, 2, 3) peuvent, grâce à des éléments enfichables et/ou assemblables ménagés dans les boîtiers partiels (1, 2, 3), être assemblés pour former le boîtier et peuvent être liés par des éléments de liaison, où les éléments enfichables et/ou assemblables sont des tourillons ou des taquets (12, 28) en saillie liés en formant une seule pièce avec un boîtier partiel (1, 2, 3) et qui peuvent s'engager dans des évidements correspondants ménagés sur un autre boîtier partiel et que, dans chaque boîtier partiel (1, 2, 3), sont disposés les composants connectés les uns aux autres et prêts à fonctionner d'un ou de plusieurs constituants de l'ensemble multimédia, où un ou plusieurs boîtiers partiels (1, 2, 3) ont à peu près une forme de pot et où l'ouverture du pot d'un ou de plusieurs boîtiers partiels a, dans une paroi (17) du boîtier, une ouverture (16, 26) conduisant vers l'extérieur du boîtier dans laquelle est monté un ventilateur, des ouvertures de ventilation (19, 19') étant ménagées dans la paroi (18) du boîtier de l'ouverture du pot se trouvant à l'opposé de la paroi (17) du boîtier portant le ventilateur.

2. Ensemble multimédia selon la revendication 1, **caractérisé par le fait que** les constituants de l'ensemble multimédia sont une unité d'alimentation en tension et/ou une unité électronique et/ou un lecteur de mémoire de données, notamment d'une mémoire de données à disque DVD et/ou à disque CD, et/ou un changeur de disque d'une mémoire de données, notamment d'une mémoire de données à disque DVD et /ou à disque CD.

3. Ensemble multimédia selon la revendication 2, **caractérisé par le fait que** l'unité électronique comporte un système électronique de téléphonie et/ou un système électronique de navigation et/ou un système électronique de radio et de synthétiseur et/ou un système électronique de réception GPS et/ou une unité de capteurs, notamment une unité de capteurs d'angle de rotation.

4. Ensemble multimédia selon l'une des revendications précédentes, **caractérisé par le fait que** les constituants de l'ensemble multimédia peuvent être connectés électriquement les uns aux autres.

5. Ensemble multimédia selon la revendication 4, **caractérisé par le fait que** les constituants peuvent être connectés électriquement les uns aux autres d'une façon amovible.

6. Ensemble multimédia selon la revendication 5, **caractérisé par le fait que** chaque constituant peut être connecté par l'intermédiaire d'un connecteur fixé définitivement à un boîtier partiel et/ou d'une prise de connecteur fixée définitivement à un boîtier partiel.

7. Ensemble multimédia selon l'une des revendications précédentes, **caractérisé par le fait que** les constituants peuvent être connectés, par l'intermédiaire d'un connecteur monté sur des conducteurs souples et/ou d'une fiche de connecteur montée sur des conducteurs souples.

8. Ensemble multimédia selon l'une des revendications précédentes, **caractérisé par le fait que** plusieurs boîtiers partiels (1, 2) peuvent liés l'un à l'autre en série pour former un paquet de boîtiers partiels.

9. Ensemble multimédia selon la revendication 8, **caractérisé par le fait que** l'un ou plusieurs boîtiers partiels (3) peuvent être liés au paquet de boîtiers partiels perpendiculairement à la disposition en série des boîtiers partiels (1, 2).

10. Ensemble multimédia selon l'une des revendications précédentes, **caractérisé par le fait que** l'un ou plusieurs boîtiers partiels (1, 2, 3) ont une paroi de boîtier extérieure périphérique.

11. Ensemble multimédia selon la revendication 10, **caractérisé par le fait que** l'ouverture (4, 5) du boîtier partiel (1, 2) peut être fermée par un couvercle (6, 7).

12. Ensemble multimédia selon la revendication 11, **caractérisé par le fait que** le couvercle (6, 7) est une pièce métallique coulée.

13. Ensemble multimédia selon l'une des revendications 10 à 12, **caractérisé par le fait que** les parois périphériques (10, 17, 18) du boîtier et/ou les couvercles (6, 7) et/ou les bases (27) forment complètement ou partiellement les parois extérieures du boîtier.

14. Ensemble multimédia selon l'une des revendications précédentes, **caractérisé par le fait que** l'un ou plusieurs boîtiers partiels et/ou couvercles sont conçus en formant une pièce unique avec des radiateurs.

15. Ensemble multimédia selon l'une des revendications précédentes, **caractérisé par le fait que** l'un ou plusieurs boîtiers partiels (2, 3) et/ou couvercles comportent des ouvertures continues de ventilation (19, 19').

16. Ensemble multimédia selon l'une des revendications précédentes, **caractérisé par le fait que** les composants électriques et/ou électroniques et/ou les cartes à circuits imprimés portant des composants électriques et/ou électroniques sont liés en conduction thermique avec une surface de base (8).

17. Ensemble multimédia selon la revendication 16, **caractérisé par le fait que** chaque surface de base est liée en conduction thermique avec des composants électriques et/ou électroniques et/ou des cartes à circuits imprimés portant des composants électriques et/ou électroniques.

18. Ensemble multimédia selon l'une des revendications précédentes, **caractérisé par le fait que** la base ou le couvercle sont conçus en formant une pièce unique avec des aubes directrices pour l'air.
